# FASCICULE DE BREVET EUROPEEN

(11) **EP 4 283 659 B1**
(45) Date de publication et mention de la délivrance du brevet: **29.01.2025**
(21) Numéro de dépôt: 23173764.4
(22) Date de dépôt: 16.05.2023
(51) Int. Cl.: H01L 21/18, H01L 21/762

(54) **PROCÉDÉ DE COLLAGE DIRECT ASSISTÉ PAR UNE BASE FORTE**
VERFAHREN ZUM DIREKT-BONDEN, MIT HILFE STARKER BASEN
METHOD FOR DIRECT BONDING USING STRONG BASES

(30) Priorité: 25.05.2022 FR 2205048
(43) Date de publication de la demande: 29.11.2023
(73) Titulaire: Commissariat à l'Energie Atomique et aux Energies Alternatives, 75015 Paris (FR)
(72) Inventeur: FOURNEL, Frank, 38054 Grenoble Cedex 9 (FR); CALVEZ, Aziliz, 38054 Grenoble Cedex 9 (FR); LARREY, Vincent, 38054 Grenoble Cedex 9 (FR); MORALES, Christophe, 38054 Grenoble Cedex 9 (FR)
(74) Mandataire: Germain Maureau

(56) Documents cités:
- WO-A1-2021/084188
- US-A1- 2006 141 746
- US-A1- 2006 273 068

## Description

La présente invention se rapporte au domaine du collage direct. Elle concerne en particulier un procédé de collage direct entre deux substrats. Selon un deuxième aspect, l'invention concerne un assemblage pouvant être obtenu avec un tel procédé.

Le collage direct est une technique maintenant bien connue et utilisée pour des applications industrielles comme la fabrication de SOI par la société SOITEC ou la société STMicroelectronics pour la production d'imageurs par exemple. Comme on l'entend dans le présent document, le collage direct est un collage spontané entre deux surfaces sans apport de couche de matière à l'interface entre les surfaces collées, et notamment sans couche épaisse de liquide c'est-à-dire sans couche d'une épaisseur supérieure à 100 nm. Il est néanmoins possible d'avoir quelques monocouches d'eau adsorbées sur les surfaces, ce qui représente entre 0.25 nm et 1.25 nm d'épaisseur, de sorte que ces surfaces sont macroscopiquement sèches.

Une caractéristique importante du collage direct est son énergie d'adhésion, c'est-à-dire l'énergie disponible pour réaliser le collage spontané. Il s'agit de l'énergie qui permet de déformer les deux surfaces pour les mettre en contact à l'echelle atomique afin que le forces de Van der Waals puissent être mises en oeuvre. Par exemple, pour deux surfaces de silicium ou d'oxyde de silicium hydrophile, l'énergie d'adhésion va typiquement de 30 à 100 mJ/m². Cette énergie d'adhésion dirige en partie la durée de la propagation de l'onde de collage, par exemple l'onde de collage se propage de façon classique en 9 secondes pour le collage direct de deux substrats de silicium de 200 mm.

Une autre caractéristique importante du collage direct est son énergie d'adhérence ou autrement appelée son énergie de collage. C'est l'énergie qu'il faut utiliser pour séparer les deux surfaces collées. Dans le cadre du collage de deux substrats de silicium recouvert d'oxyde thermique d'environ 145 nm d'épaisseur, cette adhérence varie entre 0.14J/m² et 6 J/m² typiquement.

Pour obtenir un collage spontané et fabriquer des structures multicouches stables dans la durée, on nettoie généralement les surfaces des contaminations organiques et particulaires qui sont très préjudiciables au collage direct. Par exemple, le nettoyage est réalisé préalablement sur les surfaces à coller avec une solution à base d'acide Caro obtenue avec un mélange d'acide sulfurique 96% et d'eau oxygénée 30% (3 :1) à 180°C et de SC1 (mélange d'ammoniaque 30%, d'eau oxygénée 30% et d'eau déionisée (1 :1 :5)) à 70°C. Alternativement, il est possible d'utiliser d'autres solutions de nettoyage très oxydantes comme, par exemple, des solutions aqueuses contenant de l'ozone ou encore avec un traitement utilisant une exposition à une lumière UV en présence d'ozone gazeux. L'énergie d'adhérence d'un collage SiO₂-SiO₂ (deux substrats de silicium recouvert d'environ 145 nm d'oxyde thermique par exemple) , dans une ambiance de salle blanche, avec un nettoyage chimique à base de Caro et de SC1 à 70°C, vaut environ 140mJ/m² juste après le collage, sans traitement thermique.

L'énergie de collage évolue également en fonction du traitement thermique que l'on applique après le collage réalisé à température ambiante. L'énergie d'adhérence augmente en fonction de la température des traitements thermiques. Par exemple, l'énergie de collage SiO₂-SiO₂ monte lentement pour atteindre , suivant les traitement de surface,3J/m² à 500°C et stagne ensuite jusqu'à 800°C.

Pour encore augmenter l'énergie de collage, une autre solution consiste à réaliser un traitement plasma préalablement à la mise en contact. Avec un plasma d'azote (N₂), pour un collage oxyde-oxyde, l'énergie de collage monte rapidement à environ 5 J/m² pour une température de traitement de 300°C.

Cependant, l'utilisation d'un plasma peut être incompatible avec certains substrats et/ou son utilisation rallonge les temps et/ou coûts des procédés, ce qui les rend plus difficilement industrialisables. Le traitement plasma modifie aussi la surface sur une épaisseur de quelques nanomètre (entre 1 et 10 nm). Cette modification peut perturber les futurs dispositifs. Par exemple, avec une plaque de silicium, le plasma crée une couche d'oxyde qui est difficilement maîtrisable en terme d'épaisseur et de qualité. Avec une surface d'oxyde de silicium, certains plasmas comme le plasma N2 crée des problèmes de charges interfaciales pouvant perturber le fonctionnement électrique des futurs dispositifs.

Il est également possible, comme décrit dans le document FR1912269, de rajouter une petite quantité d'une molécule présentant une fonction alcool et une fonction basique tel qu'un aminoalcool, sur les surfaces hydrophiles avant de les coller, ce qui augmente l'énergie du collage direct, sans nécessiter de traitement plasma.

Un autre état de la technique pertinent est le WO 2021/084188 A1, qui divulgue un procédé de collage direct de deux surfaces hydrophiles comprenant, une étape de dépôt d'une molécule spécifique comprenant un groupe fonctionnel hydrophile et un groupe fonctionnel basique;

le US 2006/273068 A1, qui divulgue divulgue un procédé de collage directe de deux substrats, comprenant une étape de traitement d'une surface oxydée de la première tranche avec une solution de NH4OH/H2O2 pour augmenter la force de collage; et

le US 2006/141746 A1, qui divulgue un procédé de collage direct de deux substrats comprenant une étape de une étape d'activation d'au moins une des surfaces de collage par application d'une solution d'activation comprenant une solution d'ammoniaque (NH4OH) dans l'eau.

L'un des buts de la présente invention est de remédier aux inconvénients de l'art antérieur. A cet effet, la présente invention propose un procédé de collage direct entre deux substrats le procédé comprenant les étapes de :
a) fourniture d'un premier substrat et d'un second substrat comprenant respectivement une première surface de collage hydrophile et une seconde surface de collage hydrophile,
b) dépôt sur la première et/ou sur la seconde surface de collage hydrophile d'une solution basique constituée de molécules de base forte et d'eau déionisée,
c) séchage de la première et/ou de la seconde surface de collage hydrophiles de sorte à atteindre une concentration comprise entre environ 10⁹ atome/cm² et 10¹⁵ atome/cm² de cations issus des molécules de base forte sur la première et/ou sur la seconde surface de collage hydrophiles,
d) mise en contact de la première et de la seconde surface de collage hydrophile de sorte à obtenir un collage direct spontané et un assemblage du premier substrat et du second substrat comprenant une interface de collage direct.

Ainsi réalisé, le procédé de collage direct est un collage direct spontané et immédiat. En effet, la très faible concentration de molécules basiques sur les surfaces de collage hydrophiles ne modifie pas l'énergie d'adhésion permettant de déformer les surfaces pour les mettre en contact à l'échelle atomique. Il nécessite une température de recuit de collage plus basse pour atteindre la même énergie de collage qu'en l'absence de molécule. Il n'est pas nécessaire de faire de traitement plasma. Un traitement plasma est tout de même toujours possible et ne réduit pas l'énergie de collage obtenue pour une température de recuit donnée. L'assemblage ainsi obtenu est résistant et peut-être tout de suite manipulé par des outils conventionnels de la microélectronique sans nécessiter de maintenir de manière spécifique le premier substrat en contact avec le second substrat, ni d'appliquer une quelconque pression, ni même de placer l'assemblage dans un environnement particulier de renforcement de l'énergie de collage. Par ailleurs, les étapes b) de dépôt de la solution basique et le séchage de l'étape c) n'allongent pas le temps de cycle de façon majeure. Ce sont des étapes simples à mettre en oeuvre et peu onéreuses. Les molécules de base forte utilisées en très petites quantités sont peu coûteuses.

Il est entendu dans le présent document par l'expression 'base forte' une base dont le pKa est supérieur ou égal 14 dans l'eau. La base forte se dissocie complètement dans H₂O pour donner des ions OH- et des cations en solution.

Par surface hydrophile, on entend qu'au moins une monocouche d'eau est adsorbée à sa surface à pression ambiante (i.e. de l'ordre de 1bar) dans un air ayant au moins 1% d'humidité relative. Une surface est dite hydrophile si l'angle d'une goutte d'eau est inférieur à 90° et de préférence inférieur à 50°, et encore plus préférentiellement inférieur à 5°.

Selon une possibilité, l'étape c) de séchage est réalisée de sorte que la première surface de collage hydrophile et la seconde surface de collage hydrophile sont recouvertes d'une à cinq monocouches atomiques d'H₂O (épaisseur de 0.25 à 1.25 nm). Ces surfaces sont ainsi sèches à l'échelle macroscopique, les éventuelles monocouches atomiques d'eau résiduelles en surface sont classiquement obtenues après séchage des surfaces hydrophiles.

Selon une disposition, lesdites molécules de base forte sont constituées par des molécules inorganiques, notamment des hydroxydes alcalin, hydroxydes d'alcalinoterreux ou un mélange de ces molécules.

Selon une possibilité, les molécules de base forte sont choisies parmi les bases LiOH, NaOH, KOH, RbOH, CsOH, Mg(OH)₂, Ca(OH)₂, Sr(OH)₂, Ba(OH)₂ et un mélange de ces bases.

Selon une réalisation particulière, la solution basique est déposée par dépôt à la tournette sur la première et/ou la seconde surface de collage hydrophile. Ce dépôt à la tournette, expression également connue sous la dénomination 'enduction par centrifugation' ou 'spin coating' dans la terminologie anglo-saxonne, permet d'étaler la solution basique de façon homogène grâce à une vitesse de rotation réglable du plateau, par exemple entre 0 et 500 tours/min. Cette méthode garantit que toute la surface considérée est bien recouverte.

De manière concrète, la solution basique présente une concentration en molécules de base forte comprise entre 10⁻⁸ mol/l et 10⁻² mol/l dans l'eau déionisée.

Avantageusement, l'étape c) est réalisée par centrifugation par exemple avec une vitesse de rotation d'environ 2000 tours/min de la première et/ou de la seconde surface de collage hydrophile (3,4) en particulier pendant 45 sec. La centrifugation est notamment réalisée après le dépôt à la tournette de l'étape b) de sorte à utiliser le même appareillage et éviter de déplacer les premier et second substrats.

Selon une autre disposition, l'étape b) est réalisée par trempage de la première et/ou de la seconde surface de collage hydrophile dans la solution basique.

Selon une autre variante, l'étape c) est réalisée par un séchage Marangoni.

Selon une possibilité, le procédé comprend en outre une étape e) d'application d'un traitement thermique à l'assemblage obtenu à l'étape d) à une température comprise entre 50°C et 500°C, notamment entre 50 et 350°C et en particulier entre 60 et 250°C. Ce traitement thermique de recuit de collage permet de renforcer encore l'énergie de collage tout en restant à des températures basses, c'est-à-dire inférieures ou égales à 500°C.

Il est toutefois possible de monter à des températures bien supérieures comme par exemple 900°C, 1100°C ou 1200°C si nécessaire, par exemple pour une autre contrainte que celle d'atteindre une forte l'énergie de collage, sans qu'aucune défectivité particulière ne soit observée.

Selon un mode de réalisation particulier, les premier et second substrats sont en silicium.

Selon une possibilité, la première surface de collage hydrophile et/ou la seconde surface de collage hydrophile sont formées au moins en partie par un film hydrophile dans un matériau choisi parmi l'oxyde de silicium, le nitrure de silicium, l'oxyde de cuivre et un mélange de ces matériaux.

Le film hydrophile en oxyde de silicium est choisi parmi un oxyde thermique, un oxyde déposé, et un oxyde natif.

Selon une variante de réalisation, le premier substrat fourni l'étape a) comprend une ou plusieurs premières vignettes provenant du vignetage du premier substrat de sorte à obtenir un collage direct de l'une ou plusieurs premières vignettes au second substrat.

La première surface de collage hydrophile est délimitée par la face exposée de l'une ou plusieurs premières vignettes.

Selon une autre variante, le second substrat fourni l'étape a) comprend une ou plusieurs secondes vignettes provenant du vignetage du second substrat de sorte à obtenir un collage direct entre l'une ou plusieurs premières vignettes et l'une ou plusieurs secondes vignettes.

La seconde surface de collage hydrophile est délimitée par la face exposée de l'une ou plusieurs secondes vignettes.

La présente invention permet ainsi de procéder au collage direct d'une ou plusieurs premières vignettes d'une surface de 1 mm x 1 mm sur un second substrat de 300 mm par exemple, comme de procéder au collage direct d'une ou plusieurs premières vignettes et d'une ou plusieurs secondes vignettes présentant chacune une surface d'environ 1 mm x 1 mm.

Selon un deuxième aspect, l'invention propose un assemblage comprenant un premier substrat et un second substrat en silicium comprenant respectivement une première surface de collage hydrophile et/ou une seconde surface de collage hydrophile, la première et la seconde surface de collage hydrophile étant collées par collage direct, des molécules de base forte étant disposées avec une concentration comprise entre environ 10⁹ atome/cm² et 10¹⁵ atome/cm² et notamment entre environ 10¹⁰ atome/cm² et 10¹⁴ atome/cm² à l'interface de collage direct entre le première et la seconde surface de collage hydrophiles.

Ces concentrations sont mesurées par spectrométrie de masse telle que par ICPMS (acronyme du nom anglo-saxon Inductively Coupled Plasma mass Spectroscopy) ou par TXRF (acronyme du nom anglo-saxon Total X Ray Fluorescence spectroscopy).

Il est entendu que cet assemblage présente l'énergie de collage requise pour ne pas conduire à la séparation des substrats après leur mise en contact.

Le premier substrat et le second substrat sont chacun formés par un matériau choisi parmi le LTO, LNO, le diamant, l'alumine, et des matériaux semi-conducteurs, en particulier le silicium, le germanium, des oxydes de silicium, des oxyde de germanium, des nitrures de silicium, du SiOC, le SiC, l'InP, l'AsGa, le GaN, et une combinaison de ces matériaux.

Le premier et/ou le second substrat sont recouverts par une couche d'oxyde de silicium, de nitrure de silicium, d'oxyde de cuivre ou d'un mélange de ces composés.

Selon un exemple de réalisation, le premier substrat et le second substrat fournis à l'étape a) sont des substrats de silicium présentant un diamètre compris entre 100 mm et 300 mm, en particulier 200 mm, et dans lequel la première surface de collage hydrophile et la seconde surface de collage hydrophile sont chacune formées par un film hydrophile d'oxyde de silicium.

Selon d'autres caractéristiques, le procédé de collage direct de l'invention comporte une ou plusieurs des caractéristiques optionnelles suivantes considérées seules ou en combinaison :
- La première et la seconde surface de collage fournies à l'étape a) sont préparées par un traitement CARO, SC1, à l'eau ozonée de sorte à nettoyer les contaminations particulaires et organiques et rendre les surfaces hydrophiles.
- La première surface de collage et la seconde surface de collage sont mises en contact à l'étape d) à température ambiante.
- Le dépôt selon l'étape b) d'une solution basique comprend préalablement la formation d'une préparation basique obtenue par mélange de molécules de base forte dans l'eau déionisée.
- Selon une disposition, la solution basique comprend une concentration massique comprise entre 10⁻⁸ et 10⁻⁴ g.cm⁻³ de NaOH dans l'eau déionisée en particulier concentration massique d'environ 10⁻⁵g.cm⁻³.
- Le traitement thermique de recuit de collage selon l'étape e) est réalisé sur durée d'environ 2 heures.
- La mise en contact selon l'étape c) du procédé est réalisée sous pression atmosphérique ou sous vide.
- Le traitement thermique selon l'étape d) du procédé est réalisée sous pression atmosphérique.
- Le procédé de collage direct est dépourvu de toute application de pression extérieure sur les premier et/ou second substrats à l'étape d) ou après l'étape d).
- La première et/ou la seconde surface de collage hydrophile présente, avant l'étape d) une quantité de molécules de base forte inférieure à la quantité nécessaire pour former une monocouche atomique ou à la quantité nécessaire pour saturer la totalité des sites d'accroche de la première et/ou la seconde surface de collage hydrophile.
- La première et/ou la seconde surface de collage hydrophile sont totalement formées par un film hydrophile continu dans un matériau choisi parmi un oxyde de silicium, un nitrure de silicium, un oxyde de cuivre ou d'un mélange de ces matériaux.
- La première et/ou la seconde surface de collage hydrophiles présente une rugosité inférieure à 0.5 nm RMS (Root Mean Square).
- La première et/ou la seconde surface de collage hydrophiles sont en silicium présentant un oxyde natif.
- La première et/ou la seconde surface de collage hydrophiles sont planes.
- Les premier et second substrats sont chacun indépendamment choisis parmi des substrats présentant un diamètre compris entre 2 et 12 pouces, notamment entre 200 mm et 300 mm.
- L'une ou plusieurs premières vignettes et/ou l'une ou plusieurs secondes vignettes présentent une dimension latérale ou un diamètre compris entre 100 micromètres et 5 mm, par exemple la première et/ou seconde vignette présente une surface principale globalement carrée dont les dimensions latérales sont de 100 micromètres x 100 micromètres.
- Le premier et/ou le second substrat comprend chacun au moins un composant électronique, telle qu'une puce, recouvert par un film hydrophile avant l'étape b) de dépôt de la solution basique.
- Le premier et le second substrat sont chacun indépendamment choisis parmi un substrat massif (bulk) ou un substrat composite (plusieurs couches de matériau).
- Le premier substrat et le deuxième substrats peuvent être de nature identique ou de nature différente.

D'autres aspects, buts et avantages de la présente invention apparaîtront mieux à la lecture de la description suivante de deux modes de réalisation de celle-ci, données à titre d'exemple non limitatif et fait en référence aux dessins annexés. Dans la suite de la description, par souci de simplification, des éléments identiques, similaires ou équivalents des différentes formes de réalisation portent les mêmes références numériques. Les figures ne respectent pas nécessairement l'échelle de tous les éléments représentés de sorte à améliorer leur lisibilité.
[Fig. 1] représente une vue schématique d'un dépôt d'une solution basique sur une surface hydrophile d'un premier substrat et le séchage selon une étape b) et une étape c) du procédé selon un mode de réalisation de l'invention.
[Fig. 2] représente une vue schématique d'un collage direct d'un premier substrat et d'un second substrat formant un assemblage selon une étape d) du procédé selon le mode de réalisation de la figure 1.
[Fig. 3] représente une vue schématique d'un traitement thermique appliqué à un assemblage du premier substrat et du second substrat selon une étape e) du procédé selon le mode de réalisation de la figure 1.
[Fig. 4] représente un graphique illustrant des exemples comparatifs d'énergie de collage obtenue selon le mode de réalisation de la figure 1 et un exemple témoin.
[Fig. 5] représente une vue schématique d'un collage direct de premières vignettes sur un second substrat selon une variante de réalisation de l'invention.

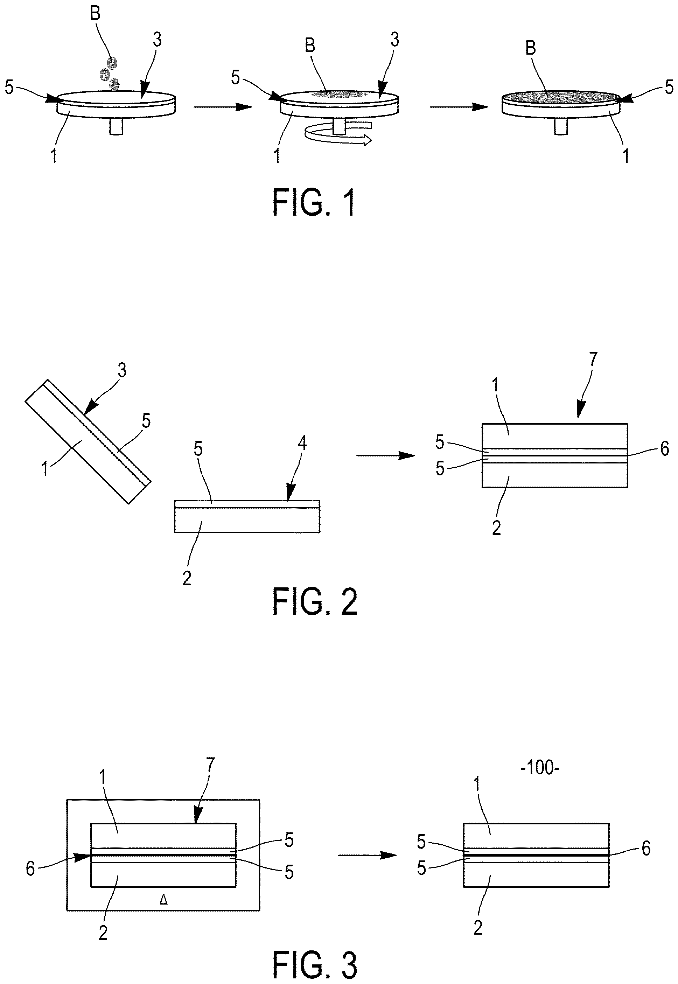

Comme illustré aux figures 1 à 3, le procédé selon l'invention comprend la fourniture d'un premier et d'un second substrats 1,2 aux surfaces de collage hydrophiles 3,4 (étape a), le dépôt d'une solution basique B sur les surfaces 3,4 (étape b) et son séchage (étape c), la mise en contact direct pour un collage direct spontané par création d'une interface de collage direct 6 (étape d) et un éventuel recuit de collage (étape e) de l'assemblage 7 ainsi formé. En particulier le premier et le second substrat 1,2 sont des tranches (ou wafer dans la terminologie anglo-saxonne) de silicium présentant une épaisseur de 725 micromètres et un diamètre de 200 mm. Ils présentent respectivement chacun une surface de collage 3 ,4 formée par un film hydrophile 5 d'oxyde de silicium thermique d'une épaisseur d'environ 145 nm. Ces surfaces de collage 3,4 sont nettoyées par un traitement Caro et un traitement SC1 permettant le retrait de contaminants organiques et particulaires, conduisant aux surfaces hydrophiles 3,4 prêtes au collage.

Une solution basique comprenant des molécules de base forte dans l'eau déionisée est ensuite déposée par dépôt à la tournette sur la surface de collage hydrophile 3 du premier substrat 1 avec une vitesse de rotation de 400 tours/min selon l'étape b) du procédé (figure 1). Au préalable une base forte constituée de NaOH a été dissoute dans l'eau déionisée de sorte à obtenir ladite solution basique avec une concentration d'environ 10⁻⁵ g.cm-3 en NaOH. Selon une variante de réalisation non visible sur les figures, la base forte est choisie parmi LiOH, KOH, RbOH, CsOH, Mg(OH)₂, Ca(OH)₂, Sr(OH)₂, Ba(OH)₂ et un mélange de ces bases.

Selon l'étape c) du procédé, la surface de collage hydrophile 3 est séchée par centrifugation jusqu'à obtenir une surface hydrophile 3 comprenant entre 1 à 5 monocouches atomique d'eau et une concentration en molécules de base forte d'environ 10¹³ at/cm². La centrifugation du séchage est réalisée à une vitesse d'environ 2000 tours/min pendant environ 45 sec.

Le second substrat 2 est soumis aux mêmes étapes b) et c) (non illustrées) que le premier substrat 1 avant leur mise en contact pour créer une interface de collage direct 6, par collage direct spontané leurs surfaces de collages hydrophiles 3,4. La propagation de l'onde de collage pour traverser les 200 mm des substrats 1,2 est d'environ 9 sec. Ceci est similaire à la durée de propagation de l'onde de collage sans présence des molécules de base forte à l'interface 6. Il en est déduit que l'énergie d'adhésion des deux surfaces de collage hydrophiles 3,4 n'a pas été modifiée par les étapes b) et c) du procédé. L'énergie du collage de l'assemblage 7 obtenue à l'issue de l'étape d) est supérieure à 140 mJ/m², valeur d'énergie de collage obtenue en absence de molécules de base forte à l'interface de collage 6, l'énergie du collage est notamment d'environ 200mJ/m² selon cet exemple de réalisation de l'invention.

Selon une variante non illustrée, les étapes b) et c) ne sont réalisées que sur l'un des premiers et seconds substrats 1,2. Selon une autre variante, la première surface hydrophile 3 et la seconde surface hydrophile 4 ne sont pas formées par un film d'oxyde de silicium 5 mais par le silicium hydrophile (i.e l'oxyde natif en surface du silicium) des substrats 1,2.

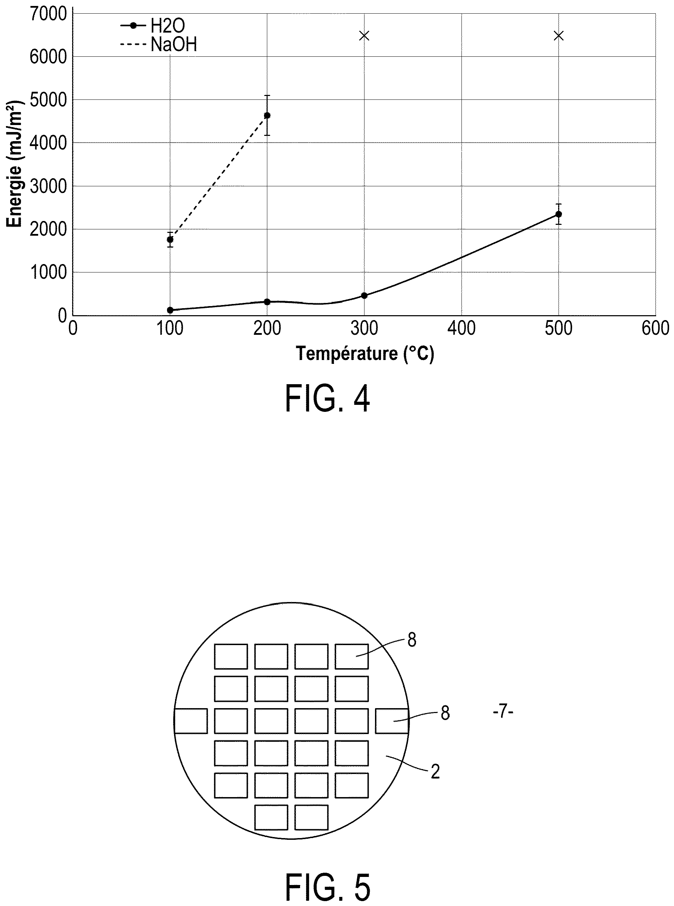

Selon une possibilité illustrée à la figure 3, un traitement thermique de recuit de collage selon l'étape e) est appliqué à pression atmosphérique sur l'assemblage 7. Les résultats sont représentés par la courbe en trait pointillé à la figure 4 illustrant l'énergie de collage sur l'axe des ordonnées et la température du recuit en degré Celsius sur l'axe des abscisses. L'énergie de collage est mesurée par exemple avec la méthode du double levier à déplacement imposée dans une atmosphère anhydre comme décrit dans l'article de F. Fournel, L. Continni, C. Morales, J. Da Fonseca, H. Moriceau, F. Rieutord, A. Barthelemy, and I. Radu, Journal of Applied Physics 111, 104907 (2012). La température est appliquée à l'assemblage 7 pendant 2h puis la mesure est réalisée à l'assemblage 7 après retour à température ambiante. Des exemples témoin ont été réalisés en parallèle sur des collages directs identiques à ceux de l'invention mais en absence de molécules de base forte sur les surfaces de collage (courbe en trait plein). Comme illustré à la figure 4, les températures de 100°C, 200°C, 300°C et 500 °C ont été évaluées pour le collage direct assisté par les molécules basiques et l'énergie de collage est nettement plus élevée que celle du collage direct non assisté dès 100°C. L'écart se creuse particulièrement après un recuit de collage à 200°C, pour lequel le collage direct assisté selon l'invention atteint 4,5 J/m² alors que le collage non assisté présente une énergie de collage inférieure à 0.5 J/m². La mesure de l'énergie de collage n'a pas pu être réalisée après les recuits à 300°C et à 500 °C car l'application de la méthode de mesure nécessitant la séparation des substrats a conduit à la casse des substrats de silicium (illustré par des croix sur le graphique de la figure 4). Ainsi, l'énergie de collage direct est supérieure à l'énergie de rupture du silicium de 5 J/m². Elle dépasse donc cette valeur dès 300°C. Le collage direct non assisté atteint seulement 2.2 J/m² après un recuit de collage à 500°C.

Selon une autre variante illustrée à la figure 5, le premier substrat 1 fourni à l'étape a) est vigneté en plusieurs premières vignettes 8 dont les faces exposées sont de premières surfaces de collage hydrophile 3. Les premières vignettes 8 sont collées selon le procédé précédemment décrit sur le second substrat 2 pleine plaque selon un collage puce-plaque également connu dans la terminologie anglo-saxonne par l'expression 'chip to wafer'. Selon encore une autre variante non illustrée, le second substrat 2 est également vigneté en plusieurs secondes vignettes et le procédé de l'invention permet le collage direct des premières vignettes 8 et des secondes vignettes.

Selon une alternative non illustrée, la première surface de collage hydrophile 3 et la seconde surface de collage hydrophile 4 sont formées au moins en partie par un film hydrophile 5 en oxyde de cuivre. Concrètement, des premier et second substrats 1,2 de silicium de 300 mm de diamètre et de 775 micromètres d'épaisseurs sont préparés de sorte à avoir des surfaces hybrides cuivre-oxyde collables en collage direct. Ces première et seconde surfaces de collage hydrophiles 3,4 sont typiquement composées de plots de cuivre de 2.5 micromètres de côté séparés par 2.5 micromètres de SiO2. On parle alors d'une surface hybride au « pitch » de 5 micromètres. Juste après le polissage mécano-chimique qui permet de rendre ces surfaces de collage 3,4 parfaitement planes et collables, et juste avant le collage, on dépose une solution de NaOH à 10-5 g/cm3 dans de l'eau déionisée par spin coating selon l'étape b). Après ce spin coating, les deux surfaces hydrophiles 3,4 sont ensuite séchées par centrifugation à 2000 tours/mn pendant 45s selon l'étape c). Ensuite les deux surfaces 3,4 sont mises en contact. L'onde de collage est alors d'environs 12 s pour traverser les 300 mm ce qui est équivalent au collage sans cette molécule basique. On recuit l'assemblage 7 à 400°C pendant 2 heures. Aucune défectivité particulière n'est observée par microscopie acoustique.

Ainsi la solution mise en place par la présente invention permet d'augmenter significativement l'énergie de collage direct, même avec des substrats de grands diamètres, avec ou sans traitement thermique réalisé à basse température, de sorte qu'elle est applicable à des substrats comportant des composants sensibles à la température. Le procédé est simple à mettre en oeuvre et les étapes de dépôt de la solution basique et le séchage des surfaces sont rapides. Les solutions basiques utilisées sont peu onéreuses, les quantités de base sont très faibles ce qui ne modifie pas l'énergie d'adhésion des substrats 1,2 et permet un collage direct spontané.

## Revendications

1. Procédé de collage direct entre deux substrats (1,2), le procédé comprenant les étapes de :
a) fourniture d'un premier substrat (1) et d'un second substrat (2) comprenant respectivement une première surface de collage hydrophile (3) et/ou une seconde surface de collage hydrophile (4),
b) dépôt sur la première et/ou sur la seconde surface de collage hydrophile (3,4) d'une solution basique (B) constituée de molécules de base forte et d'eau déionisée,
c) séchage de la première et/ou de la seconde surface de collage hydrophiles (3,4) de sorte à atteindre une concentration comprise entre environ 10⁹ atome/cm² et 10¹⁵ atome/cm² de cations issus des molécules de base forte sur la première et/ou sur la seconde surface de collage hydrophiles (3,4),
d) mise en contact de la première et de la seconde surface de collage hydrophile (3,4) de sorte à obtenir un collage direct spontané et un assemblage (7) du premier substrat (1) avec le second substrat (2) comprenant une interface de collage direct (6).

2. Procédé de collage direct selon la revendication 1, dans lequel l'étape c) de séchage est réalisée de sorte que la première surface de collage hydrophile (3) et la seconde surface de collage hydrophile (4) sont recouvertes d'une à cinq monocouches atomiques d'H₂O.

3. Procédé de collage direct selon la revendication 1 ou 2, dans lequel les molécules de base forte sont choisies parmi les bases LiOH, NaOH, KOH, RbOH, CsOH, Mg(OH)₂, Ca(OH)₂, Sr(OH)₂, Ba(OH)₂ et un mélange de ces bases.

4. Procédé de collage direct selon l'une des revendications 1 à 3, dans lequel la solution basique (B) présente une concentration en molécules de base forte comprise entre 10⁻⁸ mol/l et 10⁻² mol/l dans l'eau déionisée.

5. Procédé de collage direct selon l'une des revendications 1 à 4, dans lequel l'étape c) est réalisée par centrifugation, par exemple avec une vitesse de rotation d'environ 2000 tours/min de la première et/ou de la seconde surface de collage hydrophile (3,4) et en particulier pendant 45 sec.

6. Procédé de collage direct selon l'une des revendications 1 à 5, comprenant une étape e) d'application d'un traitement thermique à l'assemblage (7) obtenu à l'étape d) à une température comprise entre 50°C et 500°C, notamment entre 50 et 350°C et en particulier entre 60 et 250°C.

7. Procédé de collage direct selon l'une des revendications 1 à 6, dans lequel le premier et le second substrats (1,2) sont en silicium.

8. Procédé de collage direct selon l'une des revendications 1 à 7, dans lequel la première surface de collage hydrophile (3) et/ou la seconde surface de collage hydrophile (4) sont formées au moins en partie par un film hydrophile (5) dans un matériau choisi parmi l'oxyde de silicium, le nitrure de silicium, l'oxyde de cuivre et un mélange de ces matériaux.

9. Procédé de collage direct selon l'une des revendications 1 à 8, dans lequel le premier substrat (1) fourni l'étape a) comprend une ou plusieurs premières vignettes (8) provenant du vignetage du premier substrat (1) de sorte à obtenir un collage direct de l'une ou plusieurs premières vignettes au second substrat (2).

10. Assemblage (7) comprenant un premier substrat (1) et un second substrat (2) en silicium comprenant respectivement une première surface de collage hydrophile (3) et une seconde surface de collage hydrophile (4), la première et la seconde surface de collage hydrophile (3,4) étant collées par collage direct, des molécules de base forte étant disposées avec une concentration comprise entre environ 10⁹ atome/cm² et 10¹⁵ atome/cm², et notamment entre environ 10¹⁰ atome/cm² et 10¹⁴ atome/cm², à l'interface de collage direct (6) entre le première et la seconde surface de collage hydrophiles (3,4).

## Patentansprüche

1. Verfahren zur direkten Verklebung zwischen zwei Substraten (1, 2), wobei das Verfahren die Schritte umfasst zum:
a) Bereitstellen eines ersten Substrats (1) und eines zweiten Substrats (2), die eine erste hydrophile Klebefläche (3) und/oder eine zweite hydrophile Klebefläche (4) umfassen,
b) Abscheiden auf der ersten und/oder auf der zweiten hydrophilen Klebefläche (3, 4) einer basischen Lösung (B) bestehend aus Molekülen der Starken Basen und deionisiertem Wasser,
c) Trocknen der ersten und/oder der zweiten hydrophilen Klebefläche (3, 4), so dass eine Konzentration zwischen etwa 10⁹ Atome/cm² und 10¹⁵ Atome/cm² von Kation erreicht wird, die aus den Molekülen der Starken Basen der ersten und/oder der zweiten hydrophilen Klebefläche (3, 4) hervorgegangen sind,
d) In-Kontakt-bringen der ersten und der zweiten hydrophilen Klebefläche (3, 4), so dass eine spontane direkte Verklebung erhalten wird und eine Verbindung (7) des ersten Substrats (1) mit dem zweiten Substrat (2), eine Grenzfläche der direkten Verklebung (6) umfassend.

2. Verfahren zur direkten Verklebung nach Anspruch 1, wobei der Schritt c) der Trocknung derart durchgeführt wird, dass die erste hydrophile Klebefläche (3) und die zweite hydrophile Klebefläche (4) mit einer bis fünf H₂O-Monoatomschichten bedeckt sind.

3. Verfahren zur direkten Verklebung nach Anspruch 1 oder 2, wobei die Moleküle der Starken Basen aus den Basen LiOH, NaOH, KOH, RbOH, CsOH, Mg(OH)₂, Ca(OH)₂, Sr(OH)₂, Ba(OH)₂ und einer Mischung dieser Basen ausgewählt sind.

4. Verfahren zur direkten Verklebung nach einem der Ansprüche 1 bis 3, wobei die basische Lösung (B) eine Konzentration der Moleküle der Starken Basen zwischen 10⁻⁸ mol/l und 10⁻² mol/l in deionisiertem Wasser aufweist.

5. Verfahren zur direkten Verklebung nach einem der Ansprüche 1 bis 4, wobei der Schritt c) durch Zentrifugieren durchgeführt wird, beispielsweise mit einer Rotationsgeschwindigkeit von etwa 2000 Umdrehungen/min, der ersten und/oder der zweiten hydrophilen Klebefläche (3, 4), und insbesondere für 45 Sek.

6. Verfahren zur direkten Verklebung nach einem der Ansprüche 1 bis 5, einen Schritt e) der Anwendung einer Wärmebehandlung an die Verbindung (7) umfassend, die in Schritt d) erhalten wurde, bei einer Temperatur zwischen 50 °C und 500 °C, besonders zwischen 50 und 350 °C und insbesondere zwischen 60 und 250 °C.

7. Verfahren zur direkten Verklebung nach einem der Ansprüche 1 bis 6, wobei das erste und das zweite Substrat (1, 2) aus Silizium bestehen.

8. Verfahren zur direkten Verklebung nach einem der Ansprüche 1 bis 7, wobei die erste hydrophile Klebefläche (3) und/oder die zweite hydrophile Klebefläche (4) mindestens teilweise durch einen hydrophilen Film (5) aus einem Material gebildet sind, das aus Siliziumoxid, Siliziumnitrid, Kupferoxid und einer Mischung dieser Materialien ausgewählt ist.

9. Verfahren zur direkten Verklebung nach einem der Ansprüche 1 bis 8, wobei das erste Substrat (1), das Schritt a) bereitstellt, eine oder mehrere erste Vignetten (8) umfasst, die aus der Vignettierung des ersten Substrats (1) stammen, so dass eine direkte Verklebung einer oder mehrerer erster Vignetten mit dem zweiten Substrat (2) erhalten wird.

10. Verbindung (7), ein erstes Substrat (1) und ein zweites Substrat (2) aus Silizium umfassend, die eine erste hydrophile Klebefläche (3) beziehungsweise eine zweite hydrophile Klebefläche (4) umfassen, wobei die erste und die zweite hydrophile Klebefläche (3, 4) durch direkte Verklebung verklebt sind, wobei die Moleküle der Starken Basen mit einer Konzentration zwischen etwa 10⁹ Atome/cm² und 10¹⁵ Atome/cm² angeordnet sind, und besonders zwischen etwa 10¹⁰ Atome/cm² und 10¹⁴ Atome/cm², an der Grenzfläche der direkten Verklebung (6) zwischen der ersten und der zweiten hydrophilen Klebefläche (3, 4).

## Claims

1. A direct bonding method between two substrates (1, 2), the method comprising the steps of:
a) providing a first substrate (1) and a second substrate (2) respectively comprising a first hydrophilic bonding surface (3) and/or a second hydrophilic bonding surface (4),
b) depositing on the first and/or on the second hydrophilic bonding surface (3, 4) a basic solution (B) consisting of strong base molecules and deionized water,
c) drying the first and/or the second hydrophilic bonding surface (3, 4) so as to reach a concentration comprised between approximately 10⁹ atoms/cm² and 10¹⁵ atoms/cm² of cations resulting from the strong base molecules on the first and/or on the second hydrophilic bonding surface (3, 4),
d) bringing the first and the second hydrophilic bonding surface (3, 4) into contact so as to obtain a spontaneous direct bonding and an assembly (7) of the first substrate (1) with the second substrate (2) comprising a direct bonding interface (6).

2. The direct bonding method according to claim 1, wherein the drying step c) is carried out so that the first hydrophilic bonding surface (3) and the second hydrophilic bonding surface (4) are covered with one to five atomic monolayers of H₂O.

3. The direct bonding method according to claim 1 or 2, wherein the strong base molecules are selected from the bases LiOH, NaOH, KOH, RbOH, CsOH, Mg(OH)₂, Ca(OH)₂, Sr(OH)₂, Ba(OH)₂ and a mixture of these bases.

4. The direct bonding method according to any of claims 1 to 3, wherein the basic solution (B) has a concentration of strong base molecules comprised between 10⁻⁸ mol/l and 10⁻² mol/l in the deionized water.

5. The direct bonding method according to any of claims 1 to 4, wherein step c) is carried out by centrifugation, for example with a rotational speed of approximately 2000 revolutions/min of the first and/or the second hydrophilic bonding surface (3, 4) and in particular for 45 sec.

6. The direct bonding method according to any of claims 1 to 5, comprising a step e) of applying a heat treatment to the assembly (7) obtained in step d) at a temperature comprised between 50°C and 500°C, notably between 50 and 350°C and in particular between 60 and 250°C.

7. The direct bonding method according to any of claims 1 to 6, wherein the first and second substrates (1, 2) are made of silicon.

8. The direct bonding method according to any of claims 1 to 7, wherein the first hydrophilic bonding surface (3) and/or the second hydrophilic bonding surface (4) are formed at least in part by a hydrophilic film (5) in a material selected from silicon oxide, silicon nitride, copper oxide and a mixture of these materials.

9. The direct bonding method according to any of claims 1 to 8, wherein the first substrate (1) provided in step a) comprises one or more first vignettes (8) originating from the vignetting of the first substrate (1) so to obtain a direct bonding of one or more first vignettes to the second substrate (2).

10. An assembly (7) comprising a first substrate (1) and a second substrate (2) made of silicon respectively comprising a first hydrophilic bonding surface (3) and a second hydrophilic bonding surface (4), the first and the second surface hydrophilic bonding surface (3, 4) being bonded by direct bonding, strong base molecules being arranged with a concentration comprised between approximately 10⁹ atoms/cm² and 10¹⁵ atoms/cm², and notably between approximately 10¹⁰ atoms/cm² and 10¹⁴ atoms/cm², at the direct bonding interface (6) between the first and the second hydrophilic bonding surface (3, 4).
